# EUROPEAN PATENT APPLICATION

(11) **EP 4 574 427 A1**
(43) Date of publication of application: **25.06.2025**
(21) Application number: 23307241.2
(22) Date of filing: 18.12.2023
(51) Int. Cl.: B33Y 10/00, B29C 64/106, B33Y 70/00, B33Y 80/00, G03F 7/00, G03F 7/027, G03F 7/075

(54) **ACTINICALLY-CURABLE COMPOSITIONS AND METHODS FOR USE THEREOF TO MAKE A THERMOFORMED PRODUCT**

(71) Applicant: ARKEMA FRANCE, 92800 Puteaux (FR)
(72) Inventor: GOLDMAN, Trevor, BOULDER, 80301 (US); DAVENPORT, Amelia, BOULDER, 80301 (US); CRAMER, Neil, BOULDER, 80301 (US)
(74) Representative: Arkema Patent

(57) **Abstract**

An actinically-curable composition includes a polymerizable resin comprising one or more polymerizable components, a non-polymerizable silicone-based additive in an amount of about 2 wt.% to about 20 wt.%, based on the total weight of the polymerizable components, a reactive additive in an amount less than 10 wt.% of the non-polymerizable silicone-based additive, and a photoinitiator. A method for making a three-dimensional (3D) printed object comprises curing the actinically-curable composition in a 3D printing process to form the 3D printed object. A method for making a thermoformed product comprises heating a thermoplastic material to provide a pliable thermoplastic material and pressing the pliable thermoplastic material against a mold comprising a 3D printed object formed from the actinically-curable composition.

## Description

### FIELD OF THE INVENTION

The present disclosure relates to a curable chemical composition. Specifically, the present disclosure relates to an actinically-curable composition useful in 3D printing applications.

### BACKGROUND OF THE INVENTION

Plastic articles may be produced using thermoforming processes. In thermoforming processes, a plastic is heated to a pliable forming temperature and then formed into shape by a mold. The plastic may be cooled to form a thermoformed plastic article that is then released from the mold. However, it may be difficult to remove a thermoformed plastic article from the mold. If it is too difficult to remove the thermoformed plastic article from the mold, then the thermoformed plastic article may warp, crack, deform, or otherwise be damaged by the force necessary to remove the thermoformed plastic article from the mold. The mold may also be damaged, which is also undesirable. Accordingly, there is a need for materials to make molds for use in thermoforming processes that have improved release properties.

### SUMMARY OF THE INVENTION

Embodiments of the present disclosure meet this need by providing actinically-curable compositions that include a non-polymerizable silicone-based additive. The actinically-curable composition may be used in 3D printing processes to form 3D printed articles. These 3D printed articles may be used as molds in thermoforming processes. The inclusion of non-polymerizable silicone-based additives in the actinically-curable composition may result in a 3D printed article with low surface energy and minimal surface texture. These features may improve the release performance of the 3D printed article when used as a mold in thermoforming processes. Improved release performance may reduce the force required to separate thermoformed plastic articles from the mold, reducing the likelihood of damage to the thermoformed article and the mold when the thermoformed article is removed from the mold.

According to one or more embodiments described herein, an actinically-curable composition comprises a polymerizable resin comprising one or more polymerizable components, a non-polymerizable silicone-based additive in an amount of about 2 wt.% to about 20 wt.% based on the total weight of the polymerizable components, optionally a reactive additive in an amount less than 10 wt.% based on the total weight of the non-polymerizable silicone-based additive, and a photoinitiator.

According to one or more embodiments described herein, a method for making a three-dimensional (3D) printed object comprises an actinically-curable composition in a 3D printing process to form a 3D printed object. The actinically-curable composition may comprise a polymerizable resin comprising one or more polymerizable components, a non-polymerizable silicone-based additive in an amount of about 2 wt.% to about 20 wt.% based on the total weight of the polymerizable components, and a photoinitiator.

According to one or more embodiments described herein, a method for making a thermoformed product comprises heating the thermoplastic material to provide a pliable thermoplastic material and pressing the pliable thermoplastic material against a mold comprising a 3D printed object formed from an actinically curable composition. The actinically curable composition may comprise a polymerizable resin comprising one or more polymerizable components, a non-polymerizable silicone-based additive in an amount of about 2 wt.% to about 20 wt.% based on the total weight of the polymerizable components, and a photoinitiator.

This summary is provided to introduce a selection of concepts further described in the detailed description. This summary is not intended to identify key or essential features of the claimed subject matter, nor is it to be used in limiting the scope of the claimed subject matter.

Additional features and advantages of the described embodiments will be set forth in the detailed description that follows. The additional features and advantages of the described embodiments will be, in part, readily apparent to those skilled in the art from that description or recognized by practicing the described embodiments, including the detailed description that follows as well as the drawings and the claims.

### DETAILED DESCRIPTION OF THE INVENTION

As described above, molds with favorable release properties are desired for use in thermoforming processes. Embodiments of the present disclosure meet this need by providing an actinically-curable composition that comprises non-polymerizable, silicone-based additives. The actinically-curable compositions may be used to form 3D printed articles. The 3D printed articles have favorable release properties when used as molds in thermoforming processes.

### DEFINITIONS

In the present application, the term "comprise(s) a/an" means "comprise(s) one or more".

The term "actinically-curable" means that when an actinically-curable composition is exposed to actinic radiation, such as ultraviolet light, the actinically-curable composition may polymerize.

The term "cationically polymerizable resin" refers to a resin that forms polymers in the presence of cations.

The term "free radical polymerizable resin" refers to a resin capable of polymerizing when exposed to free radicals.

The terms "(meth)acrylate," "(meth)acrylate group," and "(meth)acrylate functional group" mean a (meth)acryloyloxy group with formula (-O-C(=O)-CR=CH₂), where R is hydrogen or a methyl group. It should be understood that the term "(meth)acrylate" encompasses the terms methacrylate and acrylate.

The term "oligomer" refers to molecules with a distribution of molecular weights and typically having one or more polymerizable functional groups. An oligomer may be the reaction product of two or more monomers and typically has a number averaged molecular weight greater than or equal to 500 g/mol, preferably 500 g/mol to 30,000 g/mol, more preferably 1,000 g/mol to 8,000 g/mol. An oligomer may not always have a single molecular weight. As is recognized, commercial products of a particular oligomer may contain impurities or other chemical species.

The term "monomer" refers to a molecule with one or more polymerizable functional groups. The monomer has a single molecular weight, typically below 1000 g/mol, preferably 100 to 950 g/mol. As is generally recognized in the field, commercial products of a particular monomer may contain impurities or other chemical species.

The term "photoinitiator" refers to a compound that undergoes a photoreaction on absorption of light, producing reactive species. The reactive species that are generated then initiate curing (polymerization) of the reactive components of the curable composition. Generally, when compounds present in the reactive components contain carbon-carbon double bonds, such polymerization (curing) involves reaction of such carbon-carbon double bonds.

The term "wt. %" means weight percentage. Unless otherwise mentioned, the weight percentages in a compound or a composition are expressed relative to the weight of the compound or the composition, respectively.

### EMBODIMENTS

The actinically-curable composition of the invention comprises a polymerizable resin, a non-polymerizable silicone-based additive, and a photoinitiator. The actinically-curable composition may further comprise a reactive additive.

### Polymerizable Resin

The actinically-curable composition includes a polymerizable resin. The polymerizable resin may comprise a free radical polymerizable resin. The polymerizable resin may comprise a cationically polymerizable resin. In some embodiments, the polymerizable resin may comprise both a free radical polymerizable resin and a cationically polymerizable resin.

Free radical polymerizable resins may comprise (meth)acrylate groups, allyls, thiols, and amines, and other radically polymerizable groups. The polymerizable resin may comprise at least one (meth)acrylate monomer. The polymerizable resin may comprise at least one (meth)acrylate oligomer, which, if present, is also a polymerizable component. In some embodiments, the polymerizable resin may comprise at least one (meth)acrylate monomer and at least one (meth)acrylate oligomer.

The polymerizable resin may comprise at least one (meth)acrylate monomer, which, if present, is also a polymerizable component. In one or more embodiments, the polymerizable resin may comprise a mixture of (meth)acrylate monomers having different functionalities. For example, the polymerizable component may comprise a mixture of a (meth)acrylate monomer containing a single acrylate or methacrylate group per molecule (referred to herein as "mono(meth)acrylate-functionalized compounds") and a (meth)acrylate-functionalized monomer containing 2 or more, preferably 2 or 3, acrylate and/or methacrylate groups per molecule (referred to herein as "poly(meth)acrylate-functionalized compounds"). Mono(meth)acrylate-functionalized monomers may advantageously function as a reactive diluents and reduce the viscosity of the composition.

Examples of suitable mono(meth)acrylate-functionalized monomers include, but are not limited to, mono-(meth)acrylate esters of aliphatic alcohols (wherein the aliphatic alcohol may be straight chain, branched or alicyclic and may be a mono-alcohol, a di-alcohol or a polyalcohol, provided only one hydroxyl group is esterified with (meth)acrylic acid); mono-(meth)acrylate esters of aromatic alcohols (such as phenols, including alkylated phenols); mono-(meth)acrylate esters of alkylaryl alcohols (such as benzyl alcohol); mono-(meth)acrylate esters of oligomeric and polymeric glycols such as diethylene glycol, triethylene glycol, dipropylene glycol, tripropylene glycol, polyethylene glycol, and polypropylene glycol); mono-(meth)acrylate esters of monoalkyl ethers of glycols and oligoglycols; mono-(meth)acrylate esters of alkoxylated (e.g., ethoxylated and/or propoxylated) aliphatic alcohols (wherein the aliphatic alcohol may be straight chain, branched or alicyclic and may be a mono-alcohol, a di-alcohol or a polyalcohol, provided only one hydroxyl group of the alkoxylated aliphatic alcohol is esterified with (meth)acrylic acid); mono-(meth)acrylate esters of alkoxylated (e.g., ethoxylated and/or propoxylated) aromatic alcohols (such as alkoxylated phenols); caprolactone mono(meth)acrylates; and the like.

The following compounds are specific examples of mono(meth)acrylate-functionalized monomers suitable for use in the polymerizable resin: methyl (meth)acrylate; ethyl (meth)acrylate; n-propyl (meth)acrylate; n-butyl (meth)acrylate; isobutyl (meth)acrylate; n-hexyl (meth)acrylate; 2-ethylhexyl (meth)acrylate; n-octyl (meth)acrylate; isooctyl (meth)acrylate; n-decyl (meth)acrylate; n-dodecyl (meth)acrylate; tridecyl (meth)acrylate; tetradecyl (meth)acrylate; hexadecyl (meth)acrylate; 2-hydroxyethyl (meth)acrylate; 2- and 3-hydroxypropyl (meth)acrylate; 2-methoxyethyl (meth)acrylate; 2-ethoxyethyl (meth)acrylate; 2- and 3-ethoxypropyl (meth)acrylate; tetrahydrofurfuryl (meth)acrylate; alkoxylated tetrahydrofurfuryl (meth)acrylate; 2-(2-ethoxyethoxy)ethyl (meth)acrylate; cyclohexyl (meth)acrylate; glycidyl (meth)acrylate; isodecyl (meth)acrylate; lauryl (meth)acrylate; 2-phenoxyethyl (meth)acrylate; alkoxylated phenol (meth)acrylates; alkoxylated nonylphenol (meth)acrylates; cyclic trimethylolpropane formal (meth)acrylate; isobornyl (meth)acrylate; tricyclodecanemethanol (meth)acrylate; tert-butylcyclohexanol (meth)acrylate; trimethylcyclohexanol (meth)acrylate; diethylene glycol monomethyl ether (meth)acrylate; diethylene glycol monoethyl ether (meth)acrylate; diethylene glycol monobutyl ether (meth)acrylate; triethylene glycol monoethyl ether (meth)acrylate; ethoxylated lauryl (meth)acrylate; methoxy polyethylene glycol (meth)acrylates; hydroxyl ethyl-butyl urethane (meth)acrylates; 3-(2-hydroxyalkyl)oxazolidinone (meth)acrylates; and combinations thereof.

The polymerizable resin may comprise a poly(meth)acrylate-functionalized monomer. A poly(meth)acrylate-functionalized monomer may have from 2 to 6 (meth)acrylate groups, in particular from 2 to 6 acrylate groups.

Examples of suitable poly(meth)acrylate-functionalized monomers include acrylate and methacrylate esters of polyols. Examples of suitable polyols include polyether diol, polyester diol, polycarbonate diol, polyorganosiloxane diol (e.g., a polydimethylsiloxane diol), polydiene diol including fully or partially hydrogenated polydiene diols (e.g., a polybutadiene diol), and non-polymeric aliphatic diols. Such polyols may be fully or partially esterified (with (meth)acrylic acid, (meth)acrylic anhydride, (meth)acryloyl chloride or the like), provided they contain at least two (meth)acrylate functional groups per molecule.

Exemplary poly(meth)acrylate-functionalized monomers may include bisphenol A di(meth)acrylate; hydrogenated bisphenol A di(meth)acrylate; ethylene glycol di(meth)acrylate; diethylene glycol di(meth)acrylate; triethylene glycol di(meth)acrylate; tetraethylene glycol di(meth)acrylate; polyethylene glycol di(meth)acrylate; propylene glycol di(meth)acrylate; dipropylene glycol di(meth)acrylate; tripropylene glycol di(meth)acrylate; tetrapropylene glycol di(meth)acrylate; polypropylene glycol di(meth)acrylate; polytetramethylene glycol di(meth)acrylate; 1,2-butanediol di(meth)acrylate; 2,3-butanediol di(meth)acrylate; 1,3-butanediol di(meth)acrylate; 1,4-butanediol di(meth)acrylate; 1,5-pentanediol di(meth)acrylate; 1,6-hexanediol di(meth)acrylate; 1,8-octanediol di(meth)acrylate; 1,9-nonanediol di(meth)acrylate; 1,10-nonanediol di(meth)acrylate; 1,12-dodecanediol di(meth)acrylate; neopentyl glycol di(meth)acrylate; 2-methyl-2,4-pentanediol di(meth)acrylate; polybutadiene di(meth)acrylate; cyclohexane-1,4-dimethanol di(meth)acrylate; tricyclodecane dimethanol di(meth)acrylate; metallic di(meth)acrylates; modified metallic di(meth)acrylates; glyceryl di(meth)acrylate; glyceryl tri(meth)acrylate; trimethylolethane tri(meth)acrylate; trimethylolethane di(meth)acrylate; trimethylolpropane tri(meth)acrylate; trimethylolpropane di(meth)acrylate; pentaerythritol di(meth)acrylate; pentaerythritol tri(meth)acrylate; pentaerythritol tetra(meth)acrylate, di(trimethylolpropane) diacrylate; di(trimethylolpropane) triacrylate; di(trimethylolpropane) tetraacrylate, sorbitol penta(meth)acrylate; di(pentaerythritol) tetraacrylate; di(pentaerythritol) pentaacrylate; di(pentaerythritol) hexa(meth)acrylate; tris (2-hydroxyethyl) isocyanurate tri(meth)acrylate; neopentylglycol hydroxypivalate di(meth)acrylate; as well as the alkoxylated (e.g., ethoxylated and/or propoxylated) derivatives thereof; and combinations thereof.

The polymerizable resin may comprise at least one (meth)acrylate oligomer, which, if present, would also be a polymerizable component. In one or more embodiments, the polymerizable resin may comprise a mixture of (meth)acrylate oligomers. A (meth)acrylate oligomer may be selected to enhance the flexibility, strength and/or modulus, among other attributes, of a cured polymer prepared by curing the actinically-curable composition described herein.

A (meth)acrylate oligomer may have 1 to 18 (meth)acrylate groups, in particular 2 to 6 (meth)acrylate groups, and more particularly 2 to 6 acrylate groups. A (meth)acrylate oligomer may have a number average molecular weight equal or more than 600 g/mol, in particular 800 to 15,000 g/mol, more particularly 1,000 to 5,000 g/mol.

In particular, the polymerizable resin may comprise a (meth)acrylate oligomer selected from the group consisting of epoxy (meth)acrylates, polyester (meth)acrylates, polyether (meth)acrylates, urethane (meth)acrylates, (meth)acrylated poly(meth)acrylates and mixtures thereof.

Non-limiting examples of epoxy (meth)acrylates are the reaction products of an epoxide (such as glycidyl ethers, glycidyl esters, cycloaliphatic epoxides or epoxides obtained by epoxidation of mono- and/or polyunsaturated compounds) with a (meth)acrylating agent (such as (meth)acrylic acid, (meth)acrylic anhydride, (meth)acryloyl chloride or combinations thereof). The epoxide may be selected from 1,2,3,4-diepoxybutane; 1,2,4,5-diepoxypentane; 1,2,5,6-diepoxyhexane; 1,2,7,8-diepoxyoctane; 1,2,9,10-diepoxydecane; bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(3,4-epoxycyclohexyl-5,5-spiro-3,4-epoxy)cyclohexane-1,4-dioxane, bis(3,4-epoxycyclohexylmethyl)adipate, vinylcyclohexene oxide, 4-vinylepoxycyclohexane, bis(3,4-epoxy-6-methylcyclohexylmethyl)adipate,3,4-epoxy-6-methylcyclohexy 1-3',4'-epoxy-6'-methylcyclohexanecarboxylate, methylenebis(3,4-epoxycyclohexane), dicyclopentadiene diepoxide, di(3,4-epoxycyclohexylmethyl) ether of ethylene glycol, ethylenebis(3, 4-epoxycyclohexanecarboxylate), ethylene glycol diglycidyl ether, 1,2- or 1,3-propylene glycol diglycidyl ether, 1,2-, 1,3- or 1,4-butanediol diglycidyl ether, 1,5-pentanediol diglycidyl ether, 1,6-hexanediol diglycidyl ether, 1,7-hexanediol diglycidyl ether, 1,8-octanediol diglycidyl ether, 1,9-nonanediol diglycidyl ether, 1,10-decanediol diglycidyl ether, 1,12-dodecanediol diglycidyl ether, 2-methyl-1,3-propanediol diglycidyl ether, neopentyl glycol diglycidyl ether, 2,2-diethyl-1,3-propane diol diglycidyl ether, 3-methyl-1,5-pentanediol diglycidyl ether, 3,3-dimethyl-1,5-pentanediol diglycidyl ether, 2,4-diethyl-1,5-pentanediol diglycidyl ether, 3,3-butylethyl-1,5-pentane diol diglycidyl ether, di-, tri- or tetra(ethylene glycol) diglycidyl ether, di-, tri- or tetra(1,2-propylene glycol) diglycidyl ether, di-, tri- or tetra(1,3-propylene glycol) diglycidyl ether, di-, tri- or tetra(1,4-butylene glycol) diglycidyl ether, a poly(ethylene glycol) diglycidyl ether, a poly(propylene glycol) diglycidyl ether, a poly(trimethylene glycol) diglycidyl ether, a poly(tetramethylene glycol) diglycidyl ether, a poly(ethylene glycol-co-propylene glycol) diglycidyl ether, glycerol triglycidyl ether, a polyglycerol polyglycidyl ether, trimethylolmethane triglycidyl ether, trimethylolethane triglycidyl ether, trimethylolpropane triglycidyl ether, di(trimethylolpropane) tetraglycidyl ether, pentaerythritol tetraglycidyl ether, diglycidyl cyclohexanedicarboxylate, cyclohexane diglycidyl ether, cyclohexane-1,4-dimethanol diglycidyl ether, tricyclodecane dimethanol diglycidyl ether, isosorbide diglycidyl ether, pyrocatechol diglycidyl ether, resorcinol diglycidyl ether, cardol diglycidyl ether, phloroglucinol triglycidyl ether, pyrogallol triglycidyl ether, tris(hydroxyphenyl)methane triglycidyl ether, tris(hydroxyphenyl)ethane triglycidyl ether, diglycidyl phthalate, diglycidyl terephthalate, diglycidyl isophthalate, polyglycidyl ethers of a polyether polyol obtained by the addition of one or more alkylene oxides to an aliphatic polyhydric alcohol such as ethylene glycol, propylene glycol, and glycerol, diglycidyl esters of aliphatic long-chain (C6-C22) dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, an epoxidized vegetable oil (such as epoxidized soybean oil and epoxidized linseed oil), epoxybutylstearic acid, epoxyoctylstearic acid, epoxidized polybutadiene, triglycidyl isocyanurate and the like.

Non-limiting examples of polyester (meth)acrylates are the reaction products of a hydroxyl group-terminated polyester polyol with a (meth)acrylating agent (such as (meth)acrylic acid, (meth)acrylic anhydride, (meth)acryloyl chloride or combinations thereof). The reaction may be conducted such that a significant concentration of residual hydroxyl groups remains in the polyester (meth)acrylate, or such that all or essentially all of the hydroxyl groups of the polyester polyol have been (meth)acrylated. The polyester polyols can be made by polycondensation reactions of a polyhydroxyl functional component (in particular a diol) and a polycarboxylic acid functional compound (in particular, a dicarboxylic acid or anhydride). To prepare the polyester (meth)acrylates, the hydroxyl groups of the polyester polyol are partially or fully esterified by reacting with the (meth)acrylating agent. Polyester (meth)acrylates may also be synthesized by reacting a hydroxyl-containing (meth)acrylate such as a hydroxyalkyl (meth)acrylate (e.g., hydroxyethyl acrylate) with a polycarboxylic acid. The polyhydroxyl functional and polycarboxylic acid functional components can each have linear, branched, cycloaliphatic or aromatic structures and can be used individually or as mixtures.

Non-limiting examples of polyether (meth)acrylates are the condensation reaction products of a polyetherol which is a polyether polyol with a (meth)acrylating agent (such as (meth)acrylic acid, (meth)acrylic anhydride, (meth)acryloyl chloride or combinations thereof). Suitable polyetherols can be linear or branched substances containing ether bonds and terminal hydroxyl groups. Polyetherols can be prepared by ring opening polymerization of epoxides and other oxygen-containing heterocyclic compounds (e.g., ethylene oxide, 1,2-propylene oxide, butene oxide, tetrahydrofuran and combinations thereof) with a starter molecule. Suitable starter molecules include water, hydroxyl functional materials, polyester polyols and amines. Polyetherols may also be obtained by the condensation of diols such as glycols.

Non-limiting examples of urethane (meth)acrylates are the condensation reaction products of at least one polyisocyanate (e.g., diisocyanate, triisocyanate), at least one polyol (such as a polyether polyol or a polyester polyol) and a hydroxyl-functionalized (meth)acrylate (such as 2-hydroxyethyl (meth)acrylate or 3-hydroxypropyl (meth)acrylate) to provide terminal (meth)acrylate groups. For example, the urethane (meth)acrylate may contain two, three, four or more (meth)acrylate groups per molecule. The order of addition of the components to prepare the urethane (meth)acrylate is well known in the art. For example, the hydroxyl-functionalized (meth)acrylate may be first reacted with the polyisocyanate to obtain an isocyanate-functionalized (meth)acrylate, which is then reacted with the polyol. In yet another embodiment, the polyisocyanate may be first reacted with the polyol to obtain an isocyanate-functionalized polyol, which is thereafter reacted with a hydroxyl-functionalized (meth)acrylate. Alternatively, all the components may be combined and reacted at the same time.

Non-limiting examples of (meth)acrylated poly(meth)acrylates are substances having an oligomeric (meth)acrylic backbone functionalized with one or (meth)acrylate groups (which may be at a terminus of the oligomer or pendant to the acrylic backbone). The (meth)acrylic backbone may be a homopolymer, random copolymer or block copolymer comprised of repeating units of (meth)acrylic monomers. The (meth)acrylic monomers may be any monomeric (meth)acrylate such as C1-C6 alkyl (meth)acrylates as well as functionalized (meth)acrylates such as (meth)acrylates bearing hydroxyl, carboxylic acid and/or epoxy groups. (Meth)acrylated poly(meth)acrylates may be prepared using any procedures known in the art, such as by oligomerizing (meth)acrylic monomers, at least a portion of which are functionalized with hydroxyl, carboxylic acid and/or epoxy groups (e.g., hydroxyalkyl(meth)acrylates, (meth)acrylic acid, glycidyl (meth)acrylate) to obtain a functionalized poly(meth)acrylate, which is then reacted with one or more (meth)acrylate-containing reactants to introduce the desired (meth)acrylate functional groups.

The polymerizable resin may comprise a cationically polymerizable resin. The cationically polymerizable resin may be selected from epoxides, oxetanes, vinyl ethers, vinyl amides, oxolanes, cyclic acetals, cyclic lactones, thiiranes, thiethanes, spiro orthoesters, alcohols (including polyols), ethylenically unsaturated compounds other than (meth)acrylates, derivatives thereof and mixtures thereof.

The epoxides may comprise aromatic epoxides, cycloaliphatic epoxides, oxetanes and mixtures thereof, which, if present, would be polymerizable components. Suitable epoxy-functionalized compounds capable of being cationically polymerized include glycidyl ethers, in particular mono-, di-, tri- and polyglycidyl ether compounds, and alicyclic ether compounds including those comprising residue of carboxylic acids such as, for example, alkylcarboxylic acid residual groups, alkylcycloalkylcarboxylic acid residual groups and dialkyl dicarboxylic acid residual groups. For example, the epoxy-functionalized compounds may be bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4- epoxycyclohexylmethyl-3',4'-epoxycyclohexanecarboxylate, 2-(3,4-epoxycyclohexyl-5,5-spiro-3,4-epoxy)cyclohexane-1,4-dioxane, bis(3,4-epoxycyclohexylmethyl)adipate, vinylcyclohexene oxide, limonene dioxide, bis(3,4-epoxy-6-methylcyclohexylmethyl)adipate, 3,4-epoxy-6- methylcyclohexyl-3',4'-epoxy-6'-methylcyclohexanecarboxylate, methylenebis(3, 4-epoxycyclohexane), dicyclopentadiene diepoxide, di(3,4-epoxycyclohexylmethyl) ether of ethylene glycol, ethylenebis(3, 4-epoxycyclohexanecarboxylate), epoxyhexahydrodioctylphthalate, epoxyhexahydro-di-2-ethylhexyl phthalate, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether, polyglycidyl ethers of polyether polyol obtained by the addition of one or more alkylene oxides to aliphatic polyhydric alcohols such as ethylene glycol, propylene glycol, and glycerol, diglycidyl esters of aliphatic long-chain dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, epoxidized soybean oil, epoxybutylstearic acid, epoxyoctylstearic acid, epoxidized linseed oil, epoxidized polybutadiene, and the like.

Additional suitable ethylenically unsaturated compounds capable of being cationically polymerized include vinyl ethers such as ethylene glycol divinyl ether, triethylene glycol divinyl ether and trimethylolpropane trivinyl ether; aliphatic vinyl monomers such as vinylcyclohexane; olefins such isobutylene; dienes such as butadiene; vinyl alkyl ethers; vinyl aromatic monomers such as styrene and alkylstyrenes; unsaturated polymers such as polybutadiene; derivatives of the above organic substances; and the like, at least some of which may also be polymerizable by free radical mechanisms.

The polymerizable resin content is about 70 wt.% to about 95 wt.%, based on the total weight of the actinically-curable composition. For example, the actinically-curable composition may comprise the polymerizable resin in an amount, based on the total weight of the actinically-curable composition, from about 70 wt.% to about 95 wt.%, about 75 wt.% to about 95 wt.%, about 80 wt.% to about 95 wt.%, about 85 wt.% to about 95 wt.%, about 90 wt.% to about 95 wt.%, about 70 wt.% to about 90 wt.%, about 70 wt.% to about 85 wt.%, about 70 wt.% to about 80 wt.%, about 70 wt.% to about 75 wt.%, or any range or combination of ranges formed from these endpoints.

### Non-polymerizable Silicone-based Additive

The actinically-curable composition includes a non-polymerizable silicone-based additive. An additive is "silicone-based" when the additive comprises a polymer composed of repeating units of siloxane (-O-R₂Si-O-SiR₂-, where R is an organic group). An additive is "non-polymerizable" when the functional groups of the additive do not participate in the curing process such that the additive is not covalently bound to the polymer network when the actinically-curable composition is cured.

The non-polymerizable silicone-based additive may comprise at least one functionalized siloxane. The functionalized siloxane may comprise a functional group selected from the group consisting of: polyether, polyester, (poly)alkyl, (poly)aralkyl, and combinations thereof. In one or more embodiments, the functional group is polyether.

Without intending to be bound by theory, the functional group may be selected to improve the miscibility of the non-polymerizable silicone-based additive with the polymerizable resin. For example, a siloxane functionalized with one or more of a polyether, a polyester, a (poly)alkyl, and (poly)aralkyl may have greater miscibility with (meth)acrylate monomers and (meth)acrylate oligomers included in the polymerizable resin than unfunctionalized siloxanes. Using a functionalized siloxane comprising a functional group selected from the group consisting of: polyether, polyester, (poly)alkyl, (poly)aralkyl, and combinations thereof as the non-polymerizable silicone-based additive may prevent phase separation between the non-polymerizable silicone-based additive and the polymerizable resin in the actinically-curable composition. Phase separation between the non-polymerizable silicone-based additive and the polymerizable resin may be undesirable when using the actinically-curable composition in 3D printing applications.

The siloxane of the non-polymerizable silicone-based additive is not necessarily limited. In one or more embodiments, the non-polymerizable silicone-based additive comprises functionalized polydimethylsiloxane. Polydimethylsiloxane (PDMS) may have the chemical formula CH₃[Si(CH₃)₂O]*ₙ*Si(CH₃)₃, where *n* is the number of repeating monomer [Si(CH₃)₂O] units. The polydimethylsiloxane may be functionalized at any suitable position. For example, the polydimethylsiloxane may be functionalized at an end group or at any monomer unit between the end groups. The polydimethylsiloxane may be functionalized by a functional group selected from the group consisting of: polyether, polyester, (poly)alkyl, (poly)aralkyl, and combinations thereof. In one or more embodiments, the non-polymerizable silicone-based additive comprises polyether functionalized polydimethylsiloxane. For example, the non-polymerizable silicone-based additive may comprise a commercially available polyether functionalized polydimethylsiloxane, such as BYK-333 or BYK-3760.

The actinically-curable composition may comprise the non-polymerizable silicone-based additive in an amount of about 2 wt.% to about 20 wt.%, based on the total weight of the polymerizable components. The polymerizable components include the components of the polymerizable resin and any other reactive component (excluding the 'reactive additives' mentioned below) that participates in the polymerization that may be present in the actinically-curable composition. For example, the actinically-curable composition may comprise the non-polymerizable silicone-based additive in an amount, based on the total weight of the polymerizable components, of about 2 wt.% to about 20 wt.%, about 4 wt.% to about 20 wt.%, about 6 wt.% to about 20 wt.%, about 8 wt.% to about 20 wt.%, about 10 wt.% to about 20 wt.%, about 12 wt.% to about 20 wt.%, about 14 wt.% to about 20 wt.%, about 16 wt.% to about 20 wt.%, about 18 wt.% to about 20 wt.%, about 2 wt.% to about 18 wt.%, about 2 wt.% to about 16 wt.%, about 2 wt.% to about 14 wt.%, about 2 wt.% to about 12 wt.%, about 2 wt.% to about 10 wt.%, about 2 wt.% to about 8 wt.%, about 2 wt.% to about 6 wt.%, about 2 wt.% to about 4 wt.%, or any range or combination of ranges formed from these endpoints.

Without intending to be bound by theory, including a non-polymerizable silicone-based additive in the actinically-curable composition may improve the release properties of a 3D printed article formed from the actinically-curable composition. For example, 3D printed articles formed from actinically-curable compositions comprising the non-polymerizable silicone-based additive may have low surface energy and may have minimal surface texture. These features may improve the release performance of the 3D printed article when it is used as a mold in thermoforming processes.

### Reactive Additive

The actinically-curable composition may comprise a reactive additive. The reactive additive is an optional component. In some embodiments, the actinically-curable composition does not comprise the reactive additive. In such embodiments, the actinically-curable composition is free from the reactive additive.

The reactive additive may be a polymerizable additive. An additive is "polymerizable" when the functional groups of the additive participate in the curing process such that the additive is covalently bound to the polymer network when the actinically-curable composition is cured. In one or more embodiments, the reactive additive may comprise a polymerizable functional group. The polymerizable functional group may be a cationically polymerizable functional group or a radically polymerizable functional group. The reactive additive may comprise at least one functional group selected from the group consisting of an epoxy group, an oxetanyl group, a vinyl ether group, an ethylenically unsaturated group, or an alcohol group. The ethylenically unsaturated group may be a (meth)acrylate group. While the reactive additives described herein may comprise (meth)acrylate groups, the reactive additives are distinct from the polymerizable components described hereinabove, and do not contribute to the "total weight of the polymerizable components" when determining the weight percentage of non-polymerizable silicone-based additive (e.g., 2 to 20 wt %) or the photoinitiator.

In one or more embodiments, the reactive additive may be a surfactant. A "surfactant" refers to a compound having an oleophilic moiety, which is compatible with oil, and a hydrophilic moiety, which is compatible with water.

The reactive additive may comprise a silicone-based additive. In one or more embodiments, the reactive additive may comprise at least one functionalized siloxane. The reactive additive may be a silicone-based surfactant in one or more embodiments. In some embodiments, the reactive additive may comprise a perfluoroalkyl chain. In such embodiments, the reactive additive may be a fluorine-based surfactant.

The reactive additive may be included in the actinically-curable composition in an amount less than 10 wt.% of the non-polymerizable silicone-based additive. For example, the reactive additive may be included in the actinically-curable composition in an amount less than 10 wt.%, 9 wt.%, 8 wt.%, 7 wt.%, 6 wt.%, 5 wt.%, 4 wt.%, 3 wt.%, 2 wt.%, or even 1 wt.% of the non-polymerizable silicone-based additive. In one or more embodiments, the actinically-curable composition comprises 0 wt.% reactive additive, based on the total weight of non-polymerizable silicone-based additive. In such embodiments, no reactive additive is intentionally added to actinically-curable composition.

### Photoinitiator

The actinically-curable composition may include a photoinitiator. Photoinitiators are generally divided into two classes, depending on their mode of action: radical photoinitiators and cationic photoinitiators. Cationic photoinitiators are often salts, for instance iodonium and sulfonium salts. When these salts are irradiated with UV-light, they undergo homolytic bond cleavage forming radicals that react with a proton donor to give a Brønsted or Lewis acid. The generated acid then initiates the polymerization. Radical photoinitiators can adopt two different modes of action, and are classified by mode of action as Norrish Type I and Norrish Type II photoinitiators. In some embodiments, the actinically-curable composition comprises a radical photoinitiator, such as a Norrish Type I or Norrish Type II photo-initiator.

As used herein, the term "activity" with reference to Norrish Type I and Norrish Type II activity relates to Norrish photo-initiation and analogous reactions. For instance, a photoinitiator having Norrish Type I activity would be a photoinitiator characterized by a cleavage reaction into two radical fragments of the original photoinitiator on exposure to UV light. For an initiator having Norrish Type II activity, exposure to UV light causes the abstraction of an atom, such as hydrogen, to generate the radical.

Non-limiting types of radical photoinitiators suitable for use in the curable compositions of the present disclosure include, for example, benzoins, benzoin ethers, acetophenones, α-hydroxy acetophenones, benzyl, benzyl ketals, anthraquinones, phosphine oxides, acylphosphine oxides, α-hydroxyketones, phenylglyoxylates, α-aminoketones, benzophenones, thioxanthones, xanthones, acridine derivatives, phenazene derivatives, quinoxaline derivatives, triazine compounds, benzoyl formates, aromatic oximes, metallocenes, acylsilyl or acylgermanyl compounds, camphorquinones, polymeric derivatives thereof, and mixtures thereof.

Examples of suitable radical photoinitiators include, but are not limited to, 2-methylanthraquinone, 2-ethylanthraquinone, 2-chloroanthraquinone, 2-benzyanthraquinone, 2-t-butylanthraquinone, 1,2-benzo-9,10-anthraquinone, benzyl, benzoins, benzoin ethers, benzoin, benzoin methyl ether, benzoin ethyl ether, benzoin isopropyl ether, alpha-methylbenzoin, alpha-phenylbenzoin, Michler's ketone, acetophenones such as 2,2-dialkoxybenzophenones and 1-hydroxyphenyl ketones, benzophenone, 4,4'-bis-(diethylamino) benzophenone, acetophenone, 2,2-diethyloxyacetophenone, diethyloxyacetophenone, 2-isopropylthioxanthone, thioxanthone, diethyl thioxanthone, 1,5-acetonaphthylene, benzil ketone, α-hydroxy keto, 2,4,6-trimethylbenzoyldiphenyl phosphine oxide, benzyl dimethyl ketal, 2,2-dimethoxy-1,2-diphenylethanone, 1-hydroxycylclohexyl phenyl ketone, 2-methyl-1-[4-(methylthio) phenyl] -2-morpholinopropanone-1, 2-hydroxy-2-methyl-1-phenyl-propanone, oligomeric α-hydroxy ketone, benzoyl phosphine oxides, phenylbis(2,4,6-trimethylbenzoyl)phosphine oxide, ethyl(2,4,6-trimethylbenzoyl)phenyl phosphinate, anisoin, anthraquinone, anthraquinone-2-sulfonic acid, sodium salt monohydrate, (benzene) tricarbonylchromium, benzil, benzoin isobutyl ether, benzophenone/1-hydroxycyclohexyl phenyl ketone, 50/50 blend, 3,3',4,4'-benzophenonetetracarboxylic dianhydride, 4-benzoylbiphenyl, 2-benzyl-2-(dimethylamino)-4'-morpholinobutyrophenone, 4,4'-bis(diethylamino)benzophenone, 4,4'-bis(dimethylamino)benzophenone, camphorquinone, 2-chlorothioxanthen-9-one, dibenzosuberenone, 4,4'-dihydroxybenzophenone, 2,2-dimethoxy-2-phenylacetophenone, 4-(dimethylamino)benzophenone, 4,4'-dimethylbenzil, 2,5-dimethylbenzophenone, 3,4-dimethylbenzophenone, diphenyl(2,4,6-trimethylbenzoyl)phosphine oxide /2-hydroxy-2-methylpropiophenone, 50/50 blend, 4'-ethoxyacetophenone, 2,4,6-trimethylbenzoyldiphenylphophine oxide, phenyl bis(2,4,6-trimethyl benzoyl)phosphine oxide, ferrocene, 3'-hydroxyacetophenone, 4'-hydroxyacetophenone, 3-hydroxybenzophenone, 4-hydroxybenzophenone, 1-hydroxycyclohexyl phenyl ketone, 2-hydroxy-2-methylpropiophenone, 2-methylbenzophenone, 3-methylbenzophenone, methybenzoylformate, 2-methyl-4'-(methylthio)-2-morpholinopropiophenone, phenanthrenequinone, 4' -phenoxy acetophenone, (cumene)cyclopentadienyl iron(ii) hexafluorophosphate, 9,10-diethoxy and 9,10-dibutoxyanthracene, 2-ethyl-9,10-dimethoxyanthracene, thioxanthen-9-one and combinations thereof.

In particular, suitable photoinitiators include a benzophenone (such as SpeedCure BP, SpeedCure 7005, SpeedCure 7006), a thioxanthone (such as SpeedCure 7010, SpeedCure ITX), an α-hydroxy acetophenone, an acylphosphine oxide (such as SpeedCure BPO, SpeedCure TPO, SpeedCure TPO-L); each of which is available from Sartomer Americas.

The actinically-curable composition may comprise the photoinitiator in an amount of about 0.1 wt.% to about 10 wt.%, based on the total weight of the polymerizable components. For example, the actinically-curable composition may comprise the photoinitiator in an amount, based on the total weight of the polymerizable components, of about 0.1 wt.% to about 10 wt.%, about 0.5 wt.% to about 10 wt.%, about 1 wt.% to about 10 wt. %, about 2 wt.% to about 10 wt.%, about 3 wt.% to about 10 wt.%, about 4 wt.% to about 10 wt.%, about 5 wt.% to about 10 wt.%, about 6 wt.% to about 10 wt.%, about 7 wt.% to about 10 wt.%, about 8 wt.% to about 10 wt.%, about 9 wt.% to about 10 wt.%, about 0.1 wt.% to about 9 wt.%, about 0.1 wt.% to about 8 wt.%, about 0.1 wt.% to about 7 wt.%, about 0.1 wt.% to about 6 wt.%, about 0.1 wt.% to about 5 wt.%, about 0.1 wt.% to about 4 wt.%, about 0.1 wt.% to about 3 wt.%, about 0.1 wt.% to about 2 wt.%, about 0.1 wt.% to about 1 wt.%, about 0.1 wt. % to about 0.5 wt.%, or any range or combination of ranges formed from these endpoints.

### Additional Components

The actinically-curable composition may comprise one or more additives in addition to the above-described components. The actinically-curable compositions of the present disclosure may contain one or more additives instead of or in addition to the above-mentioned components. Such additives include, but are not limited to, antioxidants, ultraviolet absorbers, photostabilizers, foam inhibitors, flow or leveling agents, colorants, pigments, dispersants (wetting agents), slip additives, fillers (other than or in addition to inorganic nanoparticles), thixotropic agents, matting agents, accelerators, adhesion promoters (such as acidic adhesion promoters), thermoplastics and other types of polymers (other than or in addition to the above-described block copolymers), waxes or other various additives, including any of the additives conventionally utilized in the coating, sealant, adhesive, molding or ink arts. In one or more embodiments, the actinically-curable composition may comprise one or more additives selected from the group consisting of ultraviolet absorbers, pigments, stabilizers, and foam inhibitors.

### Actinically-Cured Composition

The present disclosure includes an actinically-cured composition comprising the product of actinically curing the actinically-curable composition. The actinically-curable composition may be cured by exposing the actinically-curable composition to actinic radiation, and optionally heat. The actinic radiation may include UV, near-UV, visible, infrared and/or near-infrared radiation, or electron beam radiation.

The actinically-curable composition, when actinically cured, may form a solid, three-dimensional article. The solid, three-dimensional article may have a water contact angle of greater than or equal to 45°, 50°, or 55°, and less than or equal to 105°, 100°, or 95°.

The water contact angle generally refers to the angle between a water surface and a solid surface where they meet. More specifically, the water contact angle is the angle between the surface tangent on the water-vapor interface and the tangent on the solid-water interface at their intersection. The water contact angle may be used to quantify the wettability of the actinically-cured composition.

Water contact angle determination is well-known in the art. The water contact angle is the angle between a liquid surface and a solid surface where they meet. More specifically, it is the angle between the surface tangent on the solid-liquid interface at their intersection. Measurement of water contact angle may be determined by using the measurement process substantially the same as described in ASTM D5946.

### Use in 3D Printing Processes

The actinically-curable composition of the present disclosure may be used as a 3D printing composition in a 3D printing process. Accordingly, the actinically-curable composition may be used to construct a 3D printed object that may comprise the actinically-curable composition, the actinically-cured composition, or a combination of these.

Methods for making 3D printed objects may comprise providing an actinically-curable composition and curing the actinically-curable composition in a 3D printing process to form the 3D printed object. The actinically-curable composition may be any actinically-curable composition described hereinabove. In one or more embodiments, the actinically-curable composition may comprise a polymerizable resin comprising one or more polymerizable components, a non-polymerizable silicone-based additive in an amount of about 2 wt.% to about 20 wt.%, based on the total weight of the polymerizable components, and a photoinitiator.

Three-dimensional (3D) printing (also referred to as additive manufacturing) is a process in which a 3D digital model is manufactured by the accretion of construction material. The 3D printed object is created by utilizing the computer-aided design (CAD) data of an object through sequential construction of two dimensional (2D) layers or slices that correspond to cross-sections of 3D objects. The radiation can be in the form of electromagnetic waves or an electron beam. The most commonly applied energy source is ultraviolet, visible, or infrared radiation.

The 3D printing process may comprise printing a 3D printed object layer by layer or continuously. For example, a plurality of layers of an actinically-curable composition in accordance with the present disclosure may be applied to a substrate surface; the plurality of layers may be simultaneously cured (by exposure to a single dose of radiation, for example) or each layer may be successively cured before application of an additional layer of the actinically-curable composition. In some embodiments, each layer may be successively cured before the application of an additional layer, then the plurality of layers may be simultaneously cured.

Non-limiting examples of suitable 3D printing processes may include VAT polymerization, digital light printing (DLP), stereolithography (SLA), inkjet printing, multi-jet printing, piezoelectric printing, actinically-cured extrusion, liquid crystal display (LCD) printing, volumetric printing, and gel deposition printing, and hybrids of any of these. The building method may be "layer by layer" or continuous. The liquid may be in a vat, or deposited with an inkjet or gel deposition, for example.

The actinically-curable compositions of the present disclosure are especially useful as 3D printing resin formulations, that is, compositions intended for use in manufacturing three-dimensional articles using 3D printing techniques. Such three-dimensional articles may be free-standing/self-supporting and may comprise, consist essentially of, or consist of a composition in accordance with the present disclosure, whether that actinically-curable composition has been cured or not. The 3D printed object may also be a composite, comprising at least one component consisting essentially of, or consisting of, a cured composition as previously mentioned as well as at least one additional component comprised of one or more materials other than such a cured composition (for example, a metal component or a thermoplastic component or inorganic filler or fibrous reinforcement). The actinically-curable compositions of the present disclosure may be used in a three-dimensional printing operation together with another material that functions as a scaffold or support for the article formed from the actinically-curable compositions of the present disclosure.

The actinically-curable compositions of the present disclosure are useful in the practice of various types of three-dimensional fabrication or printing techniques, including methods in which construction of a three-dimensional object is performed in a step-wise or layer-by-layer manner. In such methods, layer formation may be performed by solidification (curing) of the actinically-curable composition under exposure to radiation, such as visible, UV or other actinic irradiation. For example, new layers may be formed at the top surface of the growing object or at the bottom surface of the growing object. The actinically-curable compositions of the present disclosure may also be advantageously employed in methods for the production of three-dimensional objects by additive manufacturing wherein the method is carried out continuously. For example, the object may be produced from a liquid interface. Suitable methods of this type are sometimes referred to in the art as "continuous liquid interface (or interphase) product (or printing)" ("CLIP") methods. Such methods are described, for example, in WO 2014/126830; WO 2014/126834; WO 2014/126837; and Tumbleston et al., "Continuous Liquid Interface Production of 3D Objects," Science Vol. 347, Issue 6228, pp. 1349-1352 (March 20, 2015), the entire disclosure of which is incorporated herein by reference in its entirety for all purposes.

When stereolithography is conducted above an oxygen-permeable build window, the production of an article using an actinically-curable composition in accordance with the present disclosure may be enabled in a CLIP procedure by creating an oxygen-containing "dead zone," which is a thin uncured layer of the curable composition between the window and the surface of the cured article as it is being produced. In such a process, a curable composition is used in which curing (polymerization) is inhibited by the presence of molecular oxygen; such inhibition is typically observed, for example, in curable compositions that are capable of being cured by free radical mechanisms. The desired dead zone thickness may be maintained by selecting various control parameters such as photon flux and the optical and curing properties of the curable composition. The CLIP process proceeds by projecting a continuous sequence of actinic radiation (e.g., UV) images (that may be generated by a digital light-processing imaging unit, for example) through an oxygen-permeable, actinic radiation- (e.g., UV) transparent window below a bath of the curable composition maintained in liquid form. A liquid interface below the advancing (growing) article is maintained by the dead zone created above the window. The curing article is continuously drawn out of the curable composition bath above the dead zone, which may be replenished by feeding into the bath additional quantities of the curable composition to compensate for the amounts of curable composition being cured and incorporated into the growing article.

In another embodiment, the actinically-curable composition may be supplied by ejecting it from a print head rather than supplying it from a vat. This type of process is commonly referred to as inkjet or multi jet 3D printing. One or more UV curing sources mounted just behind the inkjet print head cures the actinically-curable composition immediately after it is applied to the build surface substrate or to previously applied layers. Two or more print heads can be used in the process, which allows application of different compositions to different areas of each layer. For example, compositions of different colors or different physical properties can be simultaneously applied to create 3D printed parts of varying composition. In a common usage, support materials, which are later removed during post-processing, are deposited at the same time as the compositions used to create the desired 3D printed part. The printheads can operate at temperatures from about 25 °C to about 100 °C. Viscosities of the curable compositions are less than 30 mPa.s at the operating temperature of the printhead.

After the 3D printed object has been printed, it may be subjected to one or more post-processing steps. The post-processing steps can be selected from one or more of the following steps removal of any printed support structures, washing with water and/or organic solvents to remove residual resins, and post-curing using thermal treatment and/or actinic radiation either simultaneously or sequentially. The post-processing steps may be used to transform the freshly printed article into a finished, functional article ready to be used in its intended application.

The 3D printed object may have a water contact angle of greater than or equal to 60°, as described herein with respect to the actinically-cured composition.

### Methods for Making Thermoformed Products

The 3D printed objects formed from the actinically-curable compositions of the present disclosure may be used in methods for making thermoformed products. For example, 3D printed objects formed from the actinically-curable compositions of the present disclosure may be used as molds on which thermoplastics may be shaped during the production of thermoformed products.

Methods for making thermoformed products may include heating a thermoplastic material to provide a pliable thermoplastic material; pressing the pliable thermoplastic material against a mold comprising a 3D printed object formed from an actinically-curable composition; cooling the pliable thermoplastic material to form a thermoformed product; and separating the thermoformed product from the mold. The 3D printed object may be formed by any suitable 3D printing process. Embodiments of such 3D printing processes are described in detail hereinabove. The actinically-curable composition may be any actinically-curable composition described hereinabove. In one or more embodiments, the actinically-curable composition may comprise a polymerizable resin comprising one or more polymerizable components, a non-polymerizable silicone-based additive in an amount of about 2 wt.% to about 20 wt.%, based on the total weight of the polymerizable components, and a photoinitiator.

As described herein, a "thermoplastic" refers to any plastic polymer material that becomes pliable or moldable at certain elevated temperatures, and solidifies upon cooling. The thermoplastic material may be any suitable thermoplastic. Thermoplastics may include, for example, acrylic, nylon, polylactic acid, polybenzimidazole, polycarbonate, polyether sulfone, polyoxymethylene, polyether ether ketone, polyetherimide, polyethylene, polyphenylene oxide, polyphenylene sulfide, polypropylene, polystyrene, polyvinyl chloride, polyvinylidene fluoride, and polytetrafluoroethylene. A thermoplastic material can be a combination of one or more thermoplastics. The thermoplastic material may be in any suitable shape. For example, the thermoplastic material may be in the form of a sheet or a disk.

Without intending to be bound by theory, thermoplastics may have a relatively high molecular weight. Polymer chains of the thermoplastic, associated by intramolecular forces, may weaken with increased temperature, yielding a pliable thermoplastic material. A thermoplastic material may be heated to provide a pliable thermoplastic material. The pliable thermoplastic material may be reshaped by various techniques, including thermoforming. "Thermoforming" refers to a manufacturing process where a thermoplastic is heated to a pliable forming temperature, and formed to a specific shape by a mold to, e.g., create a product.

A pliable thermoplastic material may be pressed against a mold during the thermoforming process. In one or more embodiments, the mold may comprise a 3D printed object formed from an actinically-curable composition described hereinabove. The mold may be a composite including the 3D printed object among other suitable materials. In embodiments, the mold may be shaped such that the 3D printed object contacts the pliable thermoplastic material when the pliable thermoplastic material is pressed against the mold.

In embodiments, the mold may have a generally convex shape such that the pliable thermoplastic material may be pressed over the mold, contacting the 3D printed object. In other embodiments, the mold may have a generally concave shape such that the pliable thermoplastic material may be pressed into the mold to contact the 3D printed object.

The pliable thermoplastic material may be pressed against the mold by vacuum. For example, a vacuum may be pulled between the pliable thermoplastic material and the mold to pull pliable thermoplastic material toward the mold. Without intending to be bound by theory, applying vacuum between the thermoplastic material and the mold may remove air that may be trapped between the pliable thermoplastic material and the mold, improving the contact between the pliable thermoplastic material and the mold.

Pressing the pliable thermoplastic material against the mold may impart the shape of the mold to the pliable thermoplastic material. The pliable thermoplastic material may be cooled to form a thermoformed product. The pliable thermoplastic material may be cooled while it is pressed against the mold. The pliable thermoplastic material may be cooled by any suitable, art-recognized means. For example, the pliable thermoplastic material may be cooled through ambient cooling. "Ambient cooling" refers to heat exchange with air at ambient conditions. The pliable thermoplastic material may also be cooled by other means. For example, without limitation, the pliable thermoplastic material may be cooled by contacting the pliable thermoplastic material with a cooled or refrigerated fluid.

Cooling the pliable thermoplastic material may reduce the pliability of the thermoplastic material. In one or more embodiments, cooling the thermoplastic material may reduce the pliability of the thermoplastic material such that the thermoformed product maintains the shape imparted to the thermoplastic material by the mold.

The thermoformed product may be separated from the mold. The thermoformed product may be separated from the mold by any suitable, art-recognized means. For example, the thermoformed product may be pulled away from the mold. The thermoformed product may be pulled away from the mold using a mechanical device, using tools, by hand, or even by gravity. In some embodiments where vacuum is used to press the pliable thermoplastic material against the mold, a burst of pressurized air may be used to break the vacuum and eject the thermoformed product from the mold.

The thermoformed product may comprise excess thermoplastic material in some embodiments. In such embodiments, excess thermoplastic material may be removed from the thermoformed product. The excess thermoplastic material may be removed by any suitable, art-recognized means. For example, excess thermoplastic material may be removed by cutting, trimming, grinding, sanding, or any other suitable means.

Without intending to be bound by theory, using the actinically-curable compositions described herein to form the mold used in the thermoforming process may result in a mold with improved release properties. The improved release properties may reduce the force necessary to remove the thermoformed product from the mold. This may reduce the likelihood of damaging the thermoformed product or the mold when removing the thermoformed product from the mold. For example, as the force necessary to remove the thermoformed product from the mold increases, the likelihood of deforming, warping, cracking, or otherwise damaging the thermoformed product when pulling it away from the mold increases. This may be especially apparent in applications where the thermoformed product is removed from the mold by hand.

For example, without limitation, thermoforming processes may be used to make dental aligners. In such processes, a mold is formed taking the shape of teeth and a thermoforming process is used to form a dental aligner by pressing a thermoplastic material against the mold. It is important, for the sake of the patient, that the dental aligner is not deformed or otherwise damaged when removing the aligner from the mold. Traditionally, plaster molds have been used in such processes to form dental aligners. However, it may be difficult to remove the dental aligner from such plaster molds. As described in more detail below, molds formed from the actinically-curable compositions of the present disclosure may have improved release properties relative to conventional plaster molds, reducing the likelihood of damaging the dental aligner when it is removed from the mold. It should be understood that the thermoforming processes described herein are not limited to the production of dental aligners. The discussion of this particular application of a thermoforming process merely serves as an example of a thermoforming process, and an illustration of the benefits of improving the release properties of molds used in thermoforming processes.

### ASPECTS

Aspect 1. An actinically-curable composition comprising: (a) a polymerizable resin comprising one or more polymerizable components; (b) a non-polymerizable silicone-based additive in an amount of about 2 wt.% to about 20 wt.%, based on the total weight of the polymerizable components; (c) optionally a reactive additive in an amount less than 10 wt.%, based on the total weight of the non-polymerizable silicone-based additive; and (d) a photoinitiator.
Aspect 2. The actinically-curable composition of Aspect 1, wherein the non-polymerizable silicone-based additive comprises at least one functionalized siloxane, wherein the functional group is selected from the group consisting of: polyether, polyester, (poly)alkyl, and (poly)aralkyl.
Aspect 3. The actinically-curable composition of Aspect 2, wherein the functional group is polyether.
Aspect 4. The actinically-curable composition of Aspect 1 or 2, wherein the non-polymerizable silicone-based additive comprises functionalized polydimethylsiloxane.
Aspect 5. The actinically-curable composition of any one of Aspects 1 to 4, wherein the non-polymerizable silicone-based additive comprises polyether functionalized polydimethylsiloxane.
Aspect 6. The actinically-curable composition of any one of Aspects 1 to 5, wherein the reactive additive comprises at least one functional group selected from the group consisting of: an epoxy group, an oxetanyl group, a vinyl ether group, an ethylenically unsaturated group, and an alcohol group.
Aspect 7. The actinically-curable composition of any one of Aspects 1 to 6, wherein the reactive additive is less than 5 wt.%, based on the total weight of the non-polymerizable silicone-based additive.
Aspect 8. The actinically-curable composition of any one of Aspects 1 to 7, wherein the reactive additive is less than 1 wt.%, based on the total weight of the non-polymerizable silicone-based additive.
Aspect 9. The actinically-curable composition of any one of Aspects 1 to 8, comprising 0 wt.% reactive additive, based on the total weight of the non-polymerizable silicone-based additive.
Aspect 10. The actinically-curable composition of any one of Aspects 1 to 9, wherein the polymerizable resin comprises at least one (meth)acrylate monomer.
Aspect 11. The actinically-curable composition of any one of Aspects 1 to 9, wherein the polymerizable resin comprises at least one (meth)acrylate oligomer.
Aspect 12. The actinically-curable composition of any one of Aspects 1 to 9, wherein the polymerizable resin comprises at least one (meth)acrylate monomer and at least one (meth)acrylate oligomer.
Aspect 13. The actinically-curable composition of any one of Aspects 1 to 12, further comprising one or more additives selected from the group consisting of: ultraviolet absorbers, pigments, stabilizers, and foam inhibitors.
Aspect 14. The actinically-curable composition of any one of Aspects 1 to 13, wherein the polymerizable resin content is about 70 wt.% to about 95 wt.%, based on the total weight of the actinically-curable composition.
Aspect 15. The actinically-curable composition of any one of Aspects 1 to 14, wherein the photoinitiator content is about 0.1 wt.% to about 10 wt.%, based on the total weight of the polymerizable components.
Aspect 16. The actinically-curable composition of any one of Aspects 1 to 15, wherein, when actinically cured, forms a solid, three-dimensional article having a water contact angle of greater than or equal to 60°.
Aspect 17. A method for making a three-dimensional (3D) printed object, the method comprising curing an actinically-curable composition in a 3D printing process to form the 3D printed object, wherein the actinically-curable composition comprises: a polymerizable resin comprising one or more polymerizable components; a non-polymerizable silicone-based additive in an amount of about 2 wt.% to about 20 wt.%, based on the total weight of the polymerizable components; and a photoinitiator.
Aspect 18. The method of Aspect 17, wherein the 3D printing process is selected from the group consisting of: VAT polymerization, digital light printing (DLP), stereolithography (SLA), inkjet printing, multi-jet printing, piezoelectric printing, actinically-cured extrusion, liquid crystal display (LCD) printing, volumetric printing, and gel deposition printing and hybrids of any of these.
Aspect 19. The method of Aspect 17 or 18, wherein the 3D printed object has a water contact angle of greater than or equal to 60°.
Aspect 20. The method of any one of Aspects 17 to 19, wherein the non-polymerizable silicone-based additive component comprises at least one functionalized siloxane, wherein the functional group is selected from the group consisting of: polyether, polyester, (poly)alkyl, and (poly)aralkyl.
Aspect 21. The method of Aspect 20, wherein the functional group is polyether.
Aspect 22. The method of any one of Aspects 17 to 20, wherein the non-polymerizable silicone-based additive comprises functionalized polydimethylsiloxane.
Aspect 23. The method of any one of Aspects 17 to 22, wherein the non-polymerizable silicone-based additive component comprises polyether functionalized polydimethylsiloxane.
Aspect 24. The method of any one of Aspects 17 to 23, wherein the polymerizable resin comprises at least one (meth)acrylate monomer.
Aspect 25. The method of any one of Aspects 17 to 23, wherein the polymerizable resin comprises at least one (meth)acrylate oligomer.
Aspect 26. The method of any one of Aspects 17 to 23, wherein the polymerizable resin comprises at least one (meth)acrylate monomer and at least one (meth)acrylate oligomer.
Aspect 27. The method of any one of Aspects 17 to 26, wherein the actinically-curable composition further comprises one or more additives selected from the group consisting of: ultraviolet absorbers, pigments, stabilizers, and foam inhibitors.
Aspect 28. The method of any one of Aspects 17 to 27, wherein the actinically-curable composition comprises the polymerizable resin in an amount of about 70 wt.% to about 95 wt.%, based on the total weight of the actinically-curable composition.
Aspect 29. The method of any one of Aspects 17 to 28, wherein the actinically-curable composition comprises the photoinitiator in an amount of about 0.1 wt.% to about 10 wt.%, based on the total weight of the polymerizable components.
Aspect 30. The method of any one of Aspects 17 to 29, wherein the actinically-curable composition further comprises a reactive additive in an amount less than 10 wt.% of the non-polymerizable silicone-based additive.
Aspect 31. The actinically-curable composition of Aspect 30, wherein the reactive additive comprises at least one functional group selected from the group consisting of: an epoxy group, an oxetanyl group, a vinyl ether group, an ethylenically unsaturated group, and an alcohol group.
Aspect 32. The method of Aspect 30 or 31, wherein the actinically-curable composition comprises the reactive additive in an amount less than 5 wt.% of the non-polymerizable silicone-based additive.
Aspect 33. The method of Aspect 30 or 31, wherein the actinically-curable composition comprises the reactive additive in an amount less than 1 wt.% of the non-polymerizable silicone-based additive.
Aspect 34. The method of any one of Aspects 17 to 29, wherein the actinically-curable composition is free of reactive additive.
Aspect 35. A method for making a thermoformed product, the method comprising: heating a thermoplastic material to provide a pliable thermoplastic material; pressing the pliable thermoplastic material against a mold comprising a 3D printed object formed from an actinically-curable composition, wherein the actinically-curable composition comprises: (a) a polymerizable resin comprising one or more polymerizable components; (b) a non-polymerizable silicone-based additive in an amount of about 2 wt.% to about 20 wt.% based on the total weight of the polymerizable components; and (c) a photoinitiator; cooling the pliable thermoplastic material to form a thermoformed product; and separating the thermoformed product from the mold.
Aspect 36. The method of Aspect 35, wherein the pliable thermoplastic is pressed against the mold by vacuum.
Aspect 37. The method of Aspect 35 or 36, wherein the method further comprises trimming excess thermoplastic material from the thermoformed product.
Aspect 38. The method of any one of Aspects 35 to 37, wherein the non-polymerizable silicone-based additive component comprises at least one functionalized siloxane, wherein the functional group is selected from the group consisting of: polyether, polyester, (poly)alkyl, and (poly)aralkyl.
Aspect 39. The method of Aspect 38, wherein the functional group is polyether.
Aspect 40. The method of any one of Aspects 35 to 38, wherein the non-polymerizable silicone-based additive component comprises functionalized polydimethylsiloxane.
Aspect 41. The method of any one of Aspects 35 to 40, wherein the non-polymerizable silicone-based additive component comprises polyether functionalized polydimethylsiloxane.
Aspect 42. The method of any one of Aspects 35 to 41, wherein the polymerizable resin comprises at least one (meth)acrylate monomer.
Aspect 43. The method of any one of Aspects 35 to 41, wherein the polymerizable resin comprises at least one (meth)acrylate oligomer.
Aspect 44. The method of any one of Aspects 35 to 41, wherein the polymerizable resin comprises at least one (meth)acrylate monomer and at least one (meth)acrylate oligomer.
Aspect 45. The method of any one of Aspects 35 to 44, wherein the actinically-curable composition further comprises one or more additives selected from the group consisting of: ultraviolet absorbers, pigments, stabilizers, and foam inhibitors.
Aspect 46. The method of any one of Aspects 35 to 45, wherein the actinically-curable composition comprises the polymerizable resin in an amount of about 70 wt.% to about 95 wt.%, based on the total weight of the actinically-curable composition.
Aspect 47. The method of any one of Aspects 35 to 46, wherein the actinically-curable composition comprises the photoinitiator in an amount of about 0.1 wt.% to about 10 wt.%, based on the total weight of the polymerizable components.
Aspect 48. The method of any one of Aspects 35 to 47, wherein the actinically-curable composition further comprises a reactive additive in an amount less than 10 wt.% of the non-polymerizable silicone-based additive.
Aspect 49. The actinically-curable composition of Aspect 48, wherein the reactive additive comprises at least one functional group selected from the group consisting of: an epoxy group, an oxetanyl group, a vinyl ether group, an ethylenically unsaturated group, and an alcohol group.
Aspect 50. The method Aspect 48 or 49, wherein the actinically-curable composition comprises the reactive additive in an amount less than 5 wt.% of the non-polymerizable silicone-based additive.
Aspect 51. The method of Aspect 48 or 49, wherein the actinically-curable composition comprises the reactive additive in an amount less than 1 wt.% of the non-polymerizable silicone-based additive.
Aspect 52. The method of any one of Aspects 35 to 47, wherein the actinically-curable composition is free of reactive additive.

### EXAMPLES

A series of Comparative Examples and Examples of actinically-curable compositions were prepared. An actinically-curable composition was formed for each Comparative Example and each Example listed in Table 1, using the resins and additives listed in the table.

The resins used in the Comparative Examples and the Examples were DMG303, SprintRay Tan, and SprintRay White. SprintRay Tan and SprintRay White are commercially available from SprintRay. The additives used in the Comparative Examples and the Examples were BYK-333, BYK-3760, CN4004, and trifluoromethyl acrylate. BYK-333 is a polyether-modified PDMS. BYK-3760 is a solvent-free, polyether-modified PDMS. BYK-333 and BYK-3760 are commercially available from BYK-Chemie GmbH. CN4004 is a fluorinated monomer, 1H,1H-perfluorooctyl acrylate. CN4004 is commercially available from Sartomer Americas.

For each Comparative Example and each Example, 200 g of the resins and additives were combined and stirred using a magnetic stir plate, at room temperature, until all solids were dissolved and the actinically-curable composition was homogeneous. Once an actinically-curable composition was formed, the actinically-curable composition was used in a 3D printing process, namely a digital light processing (DLP) 3D printer, to form a mold. The mold was a model of teeth suitable for forming dental aligners. A sheet of 1 mm thermoplastic material commercially available under the name Clear Splint Biocryl from Great Lakes Dental Technologies was heated until the thermoplastic became pliable. The pliable thermoplastic material was formed to the mold and then cooled to produce a thermoformed product. Once cooled, the thermoformed product was removed from the mold.

The thermoformed product was removed from the mold by hand, by a person skilled at making dental aligners by thermoforming. The person removing the thermoformed product from the mold qualitatively evaluated the release behavior of the thermoformed product from each mold. The release behavior of the thermoformed product from the mold of each Comparative Example and Example was evaluated and given a release behavior rating on a scale from 1 to 10. A rating of 1 indicated that it was impossible to remove the thermoformed product from the mold without deforming or damaging the thermoformed product. A rating of 5 indicated that the release behavior of the thermoformed product was comparable to the release behavior of a thermoformed product from a conventional plaster mold. A rating of 10 indicated that the thermoformed product could be removed from the mold easily, without the use of tools and with minimal physical effort.

**Table 1**

| **Example** | **Resin** | **Additive** | **Additive Content** | **Release Behavior** |
|---|---|---|---|---|
| Comparative Example 1 | DMG303 | None | 0 wt.% | 3 |
| Comparative Example 2 | DMG303 | BYK-333 | 0.5 wt.% | 5 |
| Example 1 | DMG303 | BYK-333 | 5 wt.% | 8 |
| Example 2 | DMG303 | BYK-3760 | 5 wt.% | 9 |
| Comparative Example 3 | DMG303 | Trifluoromethyl acrylate | 5 wt.% | 4 |
| Comparative Example 4 | DMG303 | CN4004 | 5 wt.% | 4 |
| Comparative Example 5 | SprintRay Tan | None | 0 wt.% | 8 |
| Comparative Example 6 | SprintRay White | None | 0 wt.% | 9 |
| Example 3 | SprintRay Tan | BYK-333 | 5 wt.% | 10 |
| Example 4 | SprintRay White | BYK-333 | 5 wt.% | 10 |

As shown in Table 1, including a polyether-modified PDMS additive in the actinically-curable composition improved the release behavior of the thermoformed product from a mold formed from the actinically-curable composition. Without intending to be bound by theory, including the polyether-modified PDMS additive in the actinically-curable composition may lower the surface energy of the 3D printed mold and may minimize surface texture on the 3D printed mold. This in turn, may improve the release properties of the mold, reducing the effort need to remove the thermoformed product from the mold. The improvement in release behavior due to the inclusion of the polyether-modified PDMS additive was observed over several different resin compositions, including DMG303, SprintRay Tan, and SprintRay White. Furthermore, fluorinated additives, such as CN4004 and Trifluoromethyl acrylate in Comparative Examples 4 and 5 did not show the same improvement in release behavior as the polyether-modified PDMS additives.

It will be apparent to persons of ordinary skill in the art that various modifications and variations can be made without departing from the scope disclosed herein. Since modifications, combinations, sub-combinations, and variations of the disclosed embodiments, which incorporate the spirit and substance disclosed herein, may occur to persons of ordinary skill in the art, the scope disclosed herein should be construed to include everything within the scope of the appended claims and their equivalents.

For the purposes of defining the present technology, the transitional phrase "consisting of" may be introduced in the claims as a closed preamble term limiting the scope of the claims to the recited components or steps and any naturally occurring impurities. For the purposes of defining the present technology, the transitional phrase "consisting essentially of" may be introduced in the claims to limit the scope of one or more claims to the recited elements, components, materials, or method steps as well as any non-recited elements, components, materials, or method steps that do not materially affect the novel characteristics of the claimed subject matter.

As used in the Specification and appended Claims, the singular forms "a", "an", and "the" include plural references unless the context clearly indicates otherwise. The verb "comprises" and its conjugated forms should be interpreted as referring to elements, components or steps in a non-exclusive manner. The referenced elements, components or steps may be present, utilized or combined with other elements, components or steps not expressly referenced.

It should be understood that any two quantitative values assigned to a property may constitute a range of that property, and all combinations of ranges formed from all stated quantitative values of a given property are contemplated in this disclosure. The subject matter disclosed herein has been described in detail and by reference to specific embodiments. It should be understood that any detailed description of a component or feature of an embodiment does not necessarily imply that the component or feature is essential to the particular embodiment or to any other embodiment.

## Claims

1. An actinically-curable composition comprising:
a) a polymerizable resin comprising one or more polymerizable components;
b) a non-polymerizable silicone-based additive in an amount of about 2 wt.% to about 20 wt.%, based on the total weight of the polymerizable components;
c) optionally a reactive additive in an amount less than 10 wt.%, based on the total weight of the non-polymerizable silicone-based additive; and
d) a photoinitiator.

2. The actinically-curable composition of claim 1, wherein the non-polymerizable silicone-based additive comprises at least one functionalized siloxane, wherein the functional group is selected from the group consisting of: polyether, polyester, (poly)alkyl, and (poly)aralkyl.

3. The actinically-curable composition of claim 2, wherein the functional group is polyether.

4. The actinically-curable composition of claim 1 or 2, wherein the non-polymerizable silicone-based additive comprises functionalized polydimethylsiloxane.

5. The actinically-curable composition of any one of claims 1 to 4, wherein the non-polymerizable silicone-based additive comprises polyether functionalized polydimethylsiloxane.

6. The actinically-curable composition of any one of claims 1 to 5, wherein the reactive additive comprises at least one functional group selected from the group consisting of: an epoxy group, an oxetanyl group, a vinyl ether group, an ethylenically unsaturated group, and an alcohol group.

7. The actinically-curable composition of any one of claims 1 to 7, comprising 0 wt.% reactive additive, based on the total weight of the non-polymerizable silicone-based additive.

8. The actinically-curable composition of any one of claims 1 to 7, wherein the polymerizable resin comprises at least one (meth)acrylate monomer.

9. The actinically-curable composition of any one of claims 1 to 8, wherein the polymerizable resin comprises at least one (meth)acrylate oligomer.

10. The actinically-curable composition of any one of claims 1 to 9, further comprising one or more additives selected from the group consisting of: ultraviolet absorbers, pigments, stabilizers, and foam inhibitors.

11. The actinically-curable composition of any one of claims 1 to 10, wherein, when actinically cured, the composition forms a solid, three-dimensional article having a water contact angle of greater than or equal to 60°.

12. A method for making a three-dimensional (3D) printed object, the method comprising:
curing an actinically-curable composition in a 3D printing process to form the 3D printed object, wherein the actinically-curable composition comprises:
a polymerizable resin comprising one or more polymerizable components;
a non-polymerizable silicone-based additive in an amount of about 2 wt.% to about 20 wt.%, based on the total weight of the polymerizable components; and
a photoinitiator.

13. The method of claim 12, wherein the 3D printing process is selected from the group consisting of: VAT polymerization, digital light printing (DLP), stereolithography (SLA), inkjet printing, multi-jet printing, piezoelectric printing, actinically-cured extrusion, liquid crystal display (LCD) printing, volumetric printing, and gel deposition printing and hybrids thereof.

14. A method for making a thermoformed product, the method comprising:
heating a thermoplastic material to provide a pliable thermoplastic material;
pressing the pliable thermoplastic material against a mold comprising a 3D printed object formed from an actinically-curable composition, wherein the actinically-curable composition comprises:
a polymerizable resin comprising one or more polymerizable components;
a non-polymerizable silicone-based additive in an amount of about 2 wt.% to about 20 wt.% based on the total weight of the polymerizable components; and
a photoinitiator;
cooling the pliable thermoplastic material to form a thermoformed product; and
separating the thermoformed product from the mold.

15. The method of claim 14, wherein the pliable thermoplastic is pressed against the mold by vacuum.
